Europäisches Patentamt

European Patent Office

Office européen des brevets

(19)

(11) Publication number: **0 110 285**
A2

# EUROPEAN PATENT APPLICATION

(21) Application number: **83111625.6**

(22) Date of filing: **21.11.83**

(51) Int. Cl.³: **H 01 L 23/52**, H 01 L 21/58
// H01L21/312, H01L21/90

(30) Priority: **27.11.82 GB 8233893**

(43) Date of publication of application: **13.06.84**
**Bulletin 84/24**

(84) Designated Contracting States: **AT BE CH DE FR GB IT
LI LU NL SE**

(71) Applicant: **PRUTEC LIMITED, 142 Holborn Bars, London
EC1N 2NH (GB)**

(72) Inventor: **Jasper, Francis Emile, Rue de Liernu, 8,
B-5854 La Bruyere (BE)**
Inventor: **Peeters, Josephus Bonifacius,
Maachtstraat 136A, B-3008 Beitem-Beisem (BE)**
Inventor: **Browne, Edward Keith, Ave Beatrice de
Cusance, Braine L'Alleud (BE)**

(74) Representative: **Messulam, Alec Moses, A. Messulam &
Co. 24 Broadway, Leigh on Sea Essex SS9 1BN (GB)**

(54) Interconnection of integrated circuits.

(57) The invention describes a method of producing an electrical circuit incorporating integrated circuits on semiconductor chips, which comprises mounting the electrical components (10) which are to constitute the circuit including the unpackaged semiconductor chips on an insulating substrate (12) in such a manner that the contact areas of the components lie in a substantially flat plane, and depositing a conductive pattern over the substrate to establish electrical connection between the components of the circuit.

ACTORUM AG

## · IMPROVEMENTS IN ELECTRICAL CIRCUITS

The present invention is concerned with the production of electrical circuits and in particular with the interconnection of integrated circuits.

In the present state of the art, it is possible to manufacture large scale integrated circuits which are very compact indeed. However, full advantage is not taken of this very significant size reduction owing to the methods currently employed in establishing connections with such integrated circuits.

Various techniques are used at present for mounting semiconductor chips on circuit boards. In one technique, each semiconductor chip is individually packaged and the package has a multitude of contacts which are individually connected to contact pads on the circuit board. This results in the disadvantages that the package itself causes an unnecessary increase in size and that the contact pads which are to be connected to the package also increase the size of the circuit board. In the alternative, bare semiconductor chips are mounted on the circuit board and connected by wire bonding to the electrical circuit, and while this overcomes the first disadvantage of the pre-packaged components it still results in an unnecessarily large circuit board. Additionally, the contact pads on the semiconductor chips must be mounted around the periphery of the chips which places an unnecessary constraint on the semiconductor chip designer and reduces the interconnection density.

The present invention seeks to provide a method of establishing electrical connections with semiconductor chips which mitigates the foregoing problems and enables full advantage to be taken of the compactness afforded by integrated circuitry.

In accordance with the present invention, there is provided a method of producing an electrical circuit incorporating integrated circuits on semiconductor chips, which comprises mounting the electrical components which are to constitute the circuit including the unpackaged semiconductor chips on an insulating substrate in such a manner that the contact areas of the components lie in a substantially flat plane, and depositing a conductive pattern over the substrate to establish electrical connection between the components of the circuit.

The components to constitute the circuit are preferably mounted on the insulating substrate by a process of encapsulation in which the components are placed face down in predetermined positions on a flat surface and a resin is cast around the components.

When casting the components in resin, for example an epoxy resin, problems can arise if an air bubble is formed near the surface of the component as this may interfere with the subsequent formation of the conductive pattern over the surface of the substrate.

In order to mitigate this problem, the casting of the resin is preferably performed in two stages, resin being cast in the region immediately surrounding the components and cured under vacuum before the remainder of the resin, constituting the bulk of the substrate, is cast.

It is not essential that the whole of the substrate be formed of a resin and it is advantageous that at least part should be of metal, for example aluminium, to assist in heat dissipation. Thus, the encapsulating resin may be conveniently be cast in a mold surrounding the components and made of metal.

Because unpackaged semiconductor components are used, it is important to ensure that the deposition of the conductive pattern does not damage the components, which would occur if the deposition process calls for the use of high temperatures or corrosive chemicals, for example. In order to enable these requirements to be met, the electrically conductive pattern is preferably formed of a cured photo-polymer loaded with a conductive powder or of an organic conductor.

Advantageously, the electrical conductors interconnecting the components mounted in the circuit board are formed of a multi-layer structure containing cured polymer layers loaded with conductive powder and acting as conductors alternating with polymer layers not loaded with conductive powder and acting as insulators.

In order to provide conductors of low resistivity, it is preferred to load the photo-polymerisable material with silver powder in which the particles are in the form of flakes. The particle size is preferably in the region of 0.3 microns, this permitting the formation of circuits of high resolution

Conveniently, to form the conductors, the entire surface of the substrate is coated with a photo-polymerisable material, the latter is selectively exposed to radiation, preferably ultra-violet light, for example through a mask, so as to polymerise only the selected regions to act as conductors, and the uncured material is removed by an appropriate solvent.

As an alternative the photo-polymerisable material may be exposed to curing radiation selectively by being scanned by a beam of electrons or coherent laser light.

Advantageously, the photo-polymerisable material includes a monomer and a proportion of prepolymer.

- 4 -                    0110285

Such a material can be polymerised more readily upon exposure to ultraviolet light to form conductors of sufficient thickness and with fine resolution.

When a printed circuit is built from several layers the individual layers may be loaded with different powders. The powder may be selected in an insulating layer to alter the dielectric properties of the layer and in a conductive layer a powder less conductive than silver may be used in order intentionally to form resistors within the conductive layers. It is believed that the resistivity cannot be predictably increased by reducing the concentration of the conductive powder as the dependence of the resistivity upon concentration follows a stepped curve. If, however, a resistive layer is required to form circuit resistors then this may be achieved by suitable selection of the loading powder.

The invention will now be described further, by way of example, with reference to the accompanying drawings, in which:

Figure 1 shows a partially cut-away perspective view of six components to be interconnected mounted in a substrate, and

Figures 2a to 2e show schematically different stages in the production of a printed circuit.

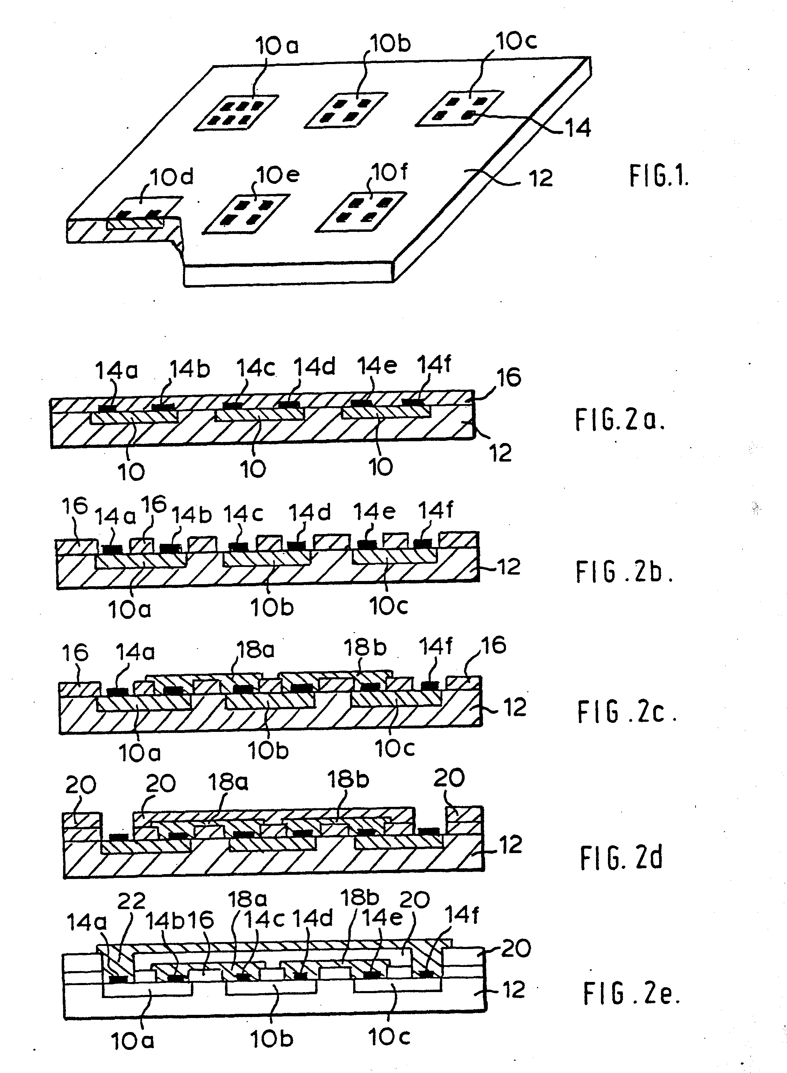

In Figure 1, there is shown a partially cut-away perspective view of a circuit which comprises six components 10a to 10f which are to be interconnected each component being in the form of a semiconductor chip. Though all the components are illustrated as being integrated circuits, it is alternatively possible that a component may consist of a discrete element such a resistor or a wound inductor.

The components 10a to 10f are cast in an insulating material 12 in such a manner that the contact pads 14 to which the circuit connections are to be made lie in the plane of the upper surface as viewed. The process for casting the individual components 10 such that the contact pads 14 should lie in a substantially flat plane is a two stage process. In the first stage, the components are placed face down and in predetermined positions on a flat surface, such as a sheet of glass having markings corresponding to the desired positions of the components. Epoxy resin is placed around each of the components and cured under vacuum, the vacuum serving to remove air bubbles and ensuring that no pits are formed in the surface on which the conductors are to be formed around the periphery of the components. After curing, the remainder of the epoxy resin is cast in a similar manner.

It is preferable for the substrate to include metallic portions for heat dissipation and this may be achieved by placing a metal matrix over the same flat surface, the components to be interconnected being disposed within the holes of the matrix, and casting the epoxy resin within the holes in order to encapsulate the components.

Some of the stages in the manufacture of a multi-layer circuit board establishing the various connections between the pads 14 of the components 10 are shown schematically in Figures 2a to 2e. The figure shows a section passing through three semiconductor chips 10a, 10b and 10c each having two contact pads in the plane of the section, the pads being designated 14a to 14f from left to right. It will be assumed that the pads 14a, 14b and 14d are to be connected to the pads 14f, 14c and 14e, respectively.

In the first step, shown in Figure 2a, a coating 16 of a photo-polymerisable material not loaded with conductive powder is applied to the entire surface of the mounted components 10. The coating is selectively exposed to ultraviolet light through a mask to cure only the areas which are to remain insulated and leave all the contact pads exposed.

Following exposure, the polymer undergoes development to remove the uncured material and to prepare the surface for subsequent recoating. After the development, the substrate may be subjected to thermal annealing by heating using infra-red heaters for 30 mins at a temperature of 150°C. Such thermal annealing gives the film better mechanical properties to withstand the further processing.

Thus, at the end of the first stage (Fig 2b), an insulating layer 16 remains over all but the contacts 14a to 14e. This layer ensures that the conductive coatings which are applied in the next stage make electrical connection only with the contact pads.

In the next stage a photo-polymerisable material loaded with a conductive powder is deposited over the entire and selectively exposed and developed to leave only two conductive bridges 18a and 18b connecting the contacts 14b and 14d to the contacts 14c and 14e, respectively (Fig 2c).

It may be possible in a circuit of very simple design to achieve all the interconnections using a single layer printed circuit made in the manner described above. However, whenever crossing over of conductors cannot be avoided it is necessary to resort to multi-layer structures. The steps described below enable the pads 14a and 14f to be connected to one another without interfering with the connections already established.

Prior to forming a second conductive layer, an insulating layer is formed to overlie the first layer of conductors by applying a coating 20 of photo-polymerisable material, which is not loaded with conductive particles to the entire upper surface. This coating 20 is then selectively cured while being masked in the areas where it is subsequently required to form a connection between the different layers of the multilayer circuit board. In the present example this involves leaving windows only over the contact pads 14a and 14e. The material is next developed to leave an insulating layer overlying only the areas to which short circuits are to be avoided (Fig 2d).

Following the formation of the insulating layer 20, the step of coating with a loaded photo-polymerisable material, and selectively curing is repeated to arrive at the structure shown in Fig 2e. In this figure, only the conductive layers have been shaded in the interest of clarity. If desired, the steps described above for forming conductive and insulating layers can be performed alternately to build up a series of layers with connections achieved through holes in the intervening insulating layers.

It is possible to load the photo-polymerisable material with particles which are thermally conductive but electrically resistive, whereupon the intervening layers may serve to enable heat to be dissipated without simultaneously creating an electrical short circuit.

It is further possible to load the photo-polymerisable material with a filler which modifies the electrical properties and/or thermal properties of the material in a different manner. For example, if it is required to form a resistor, it is possible use a material less electrically conductive than silver to achieve the desired level of resistivity. In this context it should be mentioned that the resistivity does not vary linearly with the silver concentration and one cannot predictably use the quantity of silver loading to vary the resistivity in order to form resistors.

The photo-polymerisable material may conveniently comprise four components namely a prepolymer, a monomer, a photoinitiator and a photoactivator.

The advantage of providing a prepolymer mixed with the monomer is that it enables more rapid polymerisation while the nature and the concentration of the prepolymer determine to a great extent the properties of the polymer coating. The prepolymer may conveniently be chosen from the group comprising polyol acrylates, urethane acrylates, epoxy acrylates, straight acryls, polyester acrylates, polyether acrylates and melamine acrylates.

The monomer serves to provide the appropriate rheology for the polymer and can be selected to give fast curing time and a high degree of cross linking. The prepolymer should be soluble in the monomer. Depending upon the properties desired, the monomer may be selected from amongst monoacrylates, diacrylates and triacrylates.

The photoinitiator is provided for the purpose of absorbing ultra-violet photons and forming one or more radicals which are sufficiently reactive to initiate the polymerisation. Most acrylic prepolymers and monomers do not absorb UV photons sufficiently to initiate a fast polymerisation independently. The photoinitiator may employ one of several mechanisms namely homolytic fission (eg benzoin), hydrogen abstraction (eg benzophenones) and electron transfer.

For film thicknesses below 50 microns, oxygen inhibition of polymerisation at the surface becomes noticeable and the photoactivator is provided to overcome this problem. Typically, the photoactivator is a tertiary aliphatic amine, two suitable classes of amines being ethanolamine and amino acrylates.

The silver powder for loading the polymer to render it conductive is preferably in the form of flakes. The particle size is preferably in the region 0.3 microns with maximum particle size less than 1.5 microns.

It is preferred to incorporate a wetting agent in the composition of the photo-polymerisable material in order to prevent conglomeration of the metal powder particles. A suitable agent is a surfactant available from 3M under the designation FC-430.

A photo-polymerisable material having suitable properties was made from a mixture of the following constituents :

1. epoxy-acrylate prepolymer, supplied by UCB (Belgium) under trade name EBECRYL 600.

2. 1,6-Hexanediol acrylate (HDDA)

3. UVECRYL P36 photoinitiator, supplied by UCB (Belgium),

4. UVECRYL P104 photoactivator, supplied by UCB (Belgium), and

5. FC-430 (3M), wetting agent.

When using the above composition, the development may conveniently follow the following procedure:

1. the substrate is rinsed by pouring over the monomer (HDDA);

2. the HDDA is rinsed off by pouring over of xylene; and

3. the cured layer is dried in freon vapour.

The polymerisable material is used without an electrically conductive filler where it is desired to provide an insulating layer. Where however a conductive layer is desired then a filler is employed, the most suitable being fine silver particles.

A composition found to have acceptable properties for forming circuit boards comprised around 30% resin of the composition given above and 70% of silver particles of type D31 as supplied by DEMETRON (Germany).

The method of manufacturing a printed circuit described above offers the advantage of ease of manufacture in that the electrical connections may be printed directly on to the chip. Other advantages achieved by this method are that no solder bumps are required on the chips, easy access to the network is afforded in order to connect to other circuits, the package has a flat surface and no temperature process is relied upon to achieve the interconnection thereby reducing the risk of damage by heat to the semiconductor chips.

The method does however have a disadvantage in that in the event of a faulty component being incorporated in the circuit reworking is not straight forward. Such rework can however be performed by one of two methods.

0110285

In the first method, after testing of the assembled circuit to identify the fault chip, the faulty chip is cut away by laser together with the attached surrounding parts of the circuit. A new chip is positioned and fresh connections established to the remainder of the circuit.

In order to facilitate the reconnection process, it is important to lay out the conductive tracks in such a manner that none, with the exception of the chip connections, should cross the reworked area. By this method the only connections to rework are those linking the conductive pads of the integrated circuits to their corresponding lines on the support. Furthermore, the layout should be such that the connections to the chips are formed from the uppermost conductive layer. If then aluminium pads are evaporated onto the broken conductive tracks of the substrate conventional wire bonding techniques can be utilised to interconnect the replacement chip to the circuit.

For high density connection circuits, it may be necessary to add successively to the circuit an insulating and a conductive layer which would be aimed at spreading over a large area the broken tracks to reconnect. The aluminium pads could then be evaporated through masks or by lift off techniques.

The principle of the second method of reworking faulty chips is not based upon the replacement of the faulty chip but on reprocessing of a new circuit. In this method, after identification of the faulty chip all the good chips are recovered, dismounted and cleaned and the circuit is rebuilt anew using the recovered components. This latter method has certain advantages over that previously described because the interconnection technique is essentially low cost and this allows for reprocessing in the case of a faulty chip being incorporated in the circuit with only limited cost penalties.

It is, however, advisable when relying upon the reprocessing method to carry out initial tests on the naked chips in order to increase their yield and the method best lends itself to circuits having a limited number of integrated circuits. The testing of the naked chips may conveniently be performed after the casting of the chips into the substrate whereupon it may be verified that all the chips are operational before their by the polymer circuit conductors.

As an alternative to the use of a mask to achieve selective exposure of the photo-polymerisable material, it is possible to use an electron beam focussed on the surface and to deflect the beam over the surface. The advantage of using an electron beam is that it is then possible to correct for inaccuracies in the positioning of the chips. In this case, the coordinates of each chip are measured manually by focussing a laser beam onto reference points on the chips. A calculator would then memorise the coordinates and adjust the automatic beam movement accordingly.

When a masking technique is used, positioning is critical but can be achieved, for example, by mounting the chips on a glass sheet coated using an adhesive material. The glass sheet may then serve as part of the encapsulation mould.

A field of application of the invention is in the testing of individual chips whilst they still form part of a wafer. If a photo-polymer circuit is built to establish access to the individual contact pads of the various chip on the wafer then the chips can be tested before the wafer is divided and the faulty chips recognised. Hitherto, it has not been possible to test effectively that chips incorporated within a circuit will operate satisfactorily at high speed.

### CLAIMS

1.    A method of producing an electrical circuit incorporating integrated circuits on semiconductor chips, characterised by the steps of mounting the electrical components which are to constitute the circuit, including the unpackaged semiconductor chips, on an insulating substrate in such a manner that the contact areas of the components lie in a substantially flat plane, and depositing a conductive pattern over the substrate to establish electrical connection between the components of the circuit.

2.    A method as claimed in claim 1, wherein the components to constitute the circuit are mounted on the insulating substrate by a process of encapsulation in which the components are placed face down in predetermined positions on a flat surface and a resin is cast around the components.

3.    A method as claimed in claim 2, wherein the casting of the resin is performed in two stages, resin being cast in the region immediately surrounding the components and cured under vacuum before the remainder of the resin, constituting the bulk of the substrate, is cast.

4.    A method as claimed in claim 2 or 3, wherein the components are mounted in holes in a metal matrix the resin being cast within the holes of the matrix.

5.    A method as claimed in any preceding claim, wherein the electrically conductive pattern is formed of a cured photo-polymer loaded with a conductive powder.

6. A method as claimed in claim 5, wherein the electrical conductors interconnecting the components mounted in the circuit board are formed of a multi-layer structure containing cured polymer layers loaded with conductive powder and acting as conductors alternating with polymer layers not loaded with conductive powder and acting as insulators.

7. A method as claimed in claim 5 or 6, wherein the photo-polymerisable material to form electrical conductors is loaded with silver powder in which the particles are in the form of flakes, the mean particle size is in the region of 0.3 microns.

8. A method as claimed in claim 5, 6 or 7, wherein in order to form the conductors, the entire surface of the substrate is coated with a photo-polymerisable material, the latter is selectively exposed to radiation so as to polymerise only the selected regions to act as conductors, and the uncured material is removed by an appropriate solvent.

9. A method as claimed in claim 8, wherein the photo-polymerisable material is exposed to curing radiation selectively by being scanned by a beam of electrons or coherent laser light.

10. A method as claimed in any of claims 5 to 9, wherein the photo-polymerisable material comprises :

1. epoxy-acrylate prepolymer, supplied by UCB (Belgium) under trade name EBECRYL 600.

2. 1,6-Hexanediol acrylate (HDDA)

3. UVECRYL P36 photoinitiator, supplied by UCB (Belgium),

0110285

4. UVECRYL P104 photoactivator, supplied by UCB (Belgium), and

5.  FC-430 (3M), wetting agent.

1/1

0110285

FIG.1.

FIG.2a.

FIG.2b.

FIG.2c.

FIG.2d

FIG.2e.